# EUROPEAN PATENT APPLICATION

(11) **EP 2 878 553 A1**
(43) Date of publication of application: **03.06.2015**
(21) Application number: 13823130.3
(22) Date of filing: 18.06.2013
(51) Int. Cl.: B65G 1/04, B65G 1/00

(54) **OVERHEAD TRAVELING VEHICLE SYSTEM AND CONTROL METHOD FOR OVERHEAD TRAVELING VEHICLE SYSTEM**

(30) Priority: 26.07.2012 JP 2012165563
(71) Applicant: Murata Machinery, Ltd., Kyoto-shi, Kyoto 601-8326 (JP)
(72) Inventor: OTA Tatsuji, Inuyama-shi Aichi 484-8502 (JP)
(74) Representative: Zimmermann, Tankred Klaus
(86) International application number: PCT/JP2013/066701
(87) International publication number: WO 2014/017222

(57) **Abstract**

Articles are prevented from coming into contact with a pair of rails that make up a track (10) for a local carriage (8) when being raised or lowered between the rails. An overhead traveling vehicle (4) and the local carriage (8), each of which has a hoist (22, 27), travel directly over load ports (16, 17). The track (10) for the local carriage (8) is made up of a pair of rails directly under a track (6) for the overhead traveling vehicle (4), and articles vertically pass between the pair of rails due to the hoist (22) of the overhead traveling vehicle (4). A sensor (40), which detects an article that is horizontally swinging in a direction orthogonal to the lengthwise direction of the track (10) for the local carriage (8) in the horizontal plane, is provided at least at a position that is under the track (10) for the local carriage (8) and outside of the raising and lowering path of an article that is not horizontally swinging, and the overhead traveling vehicle (4) and the local carriage (8) stop the raising and lowering of the hoists (22, 27) when the sensor (40) detects an article that is horizontally swinging.

## Description

### BACKGROUND OF THE INVENTION

### 1. Field of the Invention

This invention relates to an overhead traveling vehicle system, and in particular relates to a system in which an overhead traveling vehicle track and a local carriage track are arranged in a vertically overlapping manner over a load port.

### 2. Description of the Related Art

The inventor of the present invention has proposed arranging an overhead traveling vehicle track, a local carriage track, and buffers in a vertically overlapping manner directly over a load port (Patent Literature 1: JP 2012-111635A). The local carriage track is made up of a pair of rails, and articles are raised and lowered between the rails by a hoist of the overhead traveling vehicle. This makes it possible to stock buffers with articles that are to be carried to and from the load port, and makes it possible for both the overhead traveling vehicle and the local carriage to access the load port. However, with this system, there is the possibility of contact with the rails when the articles are raised and lowered between the rails.

### Citation List

### Patent Literature

Patent Literature 1: JP 2012-111635A

### SUMMARY OF THE INVENTION

An object of this invention is to prevent contact between articles and a pair of rails making up a local carriage track when the articles are raised and lowered between the rails.

An overhead traveling vehicle system according to this invention comprises:
overhead traveling vehicles that have a hoist for raising and lowering an article;
a track for the overhead traveling vehicle;
a load port provided in a front surface of a processing device;
a local carriage track that is arranged at a position that is directly over the load port and directly under the overhead traveling vehicle track, is arranged parallel to the overhead traveling vehicle track, and comprises a pair of rails;
a local carriage that includes a hoist for raising and lowering an article and travels along the local carriage track; and
a sensor that detects an article horizontally swinging in a direction orthogonal to a lengthwise direction of the local carriage track in a horizontal plane,
wherein the pair of rails of the local carriage track are configured to allow articles pass vertically between the pair of rails by means of the hoists of the overhead traveling vehicles,
both the overhead traveling vehicles and the local carriage are configured to carry articles to and from the load port by means of the hoists,
the sensor is provided at least at a position that is under the local carriage track and is outside of a raising and lowering path of an article that is not horizontally swinging, and
the overhead traveling vehicles and the local carriage are each configured to stop the raising and lowering of the hoist when the sensor detects an article that is horizontally swinging.

A control method for an overhead traveling vehicle system according to this invention controls an overhead traveling vehicle system that comprising
overhead traveling vehicles that have a hoist for raising and lowering an article, a track for the overhead traveling vehicle,
a load port provided in a front surface of a processing device,
a local carriage track that is arranged at a position that is directly over the load port and directly under the overhead traveling vehicle track, is arranged parallel to the overhead traveling vehicle track, and comprises a pair of rails, and
a local carriage that includes a hoist for raising and lowering an article and travels along the local carriage track,
the pair of rails of the local carriage track being configured to allow articles pass vertically between the pair of rails by means of the hoists of the overhead traveling vehicles, and
both the overhead traveling vehicles and the local carriage being configured to carry articles to and from the load port by means of the hoists, the control method comprising:
a step for providing a sensor at least at a position that is under the local carriage track and is outside of a raising and lowering path of an article that is not horizontally swinging, the sensor detecting an article horizontally swinging in a direction orthogonal to a lengthwise direction of the local carriage track in a horizontal plane; and
a step for causing the overhead traveling vehicles and the local carriage to stop the raising and lowering of the hoists when the sensor detects an article that is horizontally swinging.

In hoists, multiple suspending members such as belts are attached to an elevation platform, the elevation platform is raised and lowered by winding and unwinding the suspending members, and articles are held by a chuck or the like of the elevation platform. When an article is raised, the article will easily start oscillating if the winding amount is not the same between the suspending members. When lowering the article, if the suspending members are unwound by gravitational force from the article while applying braking by means of a winding motor for the suspending member, the amount of oscillation can be reduced compared to the case of raising. Since the article passes through the gap between the pair of rails, there is the risk of coming into contact with the rails if the article is horizontally swinging. In view of this, horizontal swinging is detected under the local carriage track, and the hoist is stopped if horizontal swinging is detected. The raising of the article can thus be stopped before coming into contact with the rails. Since the sensor is provided at a position outside of the raising and lowering path of an article that is not horizontally swinging, there is a little possibility of coming into contact with an article and becoming damaged. Also, the signal from the sensor can be used with both the overhead traveling vehicles and the local carriage. Note that the overhead traveling vehicles and the local carriage never transfer articles to the same load port at the same time.

It is preferable that the sensor includes a light projecting element that projects light along an optical axis that is parallel to the local carriage track and is outside of the raising and lowering path of an article that is not swinging, and a light receiving element that detects blockage of the optical axis by an article that is horizontally swinging. According to this, the horizontal swinging of an article is easily and reliably detected based on whether or not the article is blocking the optical axis, and it is possible to more reliably prevent the article from coming into contact with the rails. Also, the light projecting element and the light receiving element can be arranged at positions whether they do not interfere with articles.

It is further preferable that the sensors is provided at positions both under and over the local carriage track, the positions being outside of the raising and lowering path of an article that is not horizontally swinging. According to this, it is possible to prevent an article from horizontally swinging and coming into contact with the rails when the article is raised from the load port to an overhead traveling vehicle or the local carriage, and prevent an article from horizontally swinging and coming into contact with the rails also when the article is lowered from an overhead traveling vehicle to the load port.

It is particularly preferable that communication terminals are respectively provided on the overhead traveling vehicle track and the local carriage track, and a switch is provided that establishes communication selectively between the overhead traveling vehicles or the local carriage and one of the communication terminals based on a condition that the sensor does not detect an article that is horizontally swinging. The overhead traveling vehicles and the local carriage are configured to carry articles to and from the load port while communicating with the communication terminal. Also, when the sensor detects an article that is horizontally swinging, communication performed by the communication terminal with the overhead traveling vehicles or the local carriage is cut off, and the overhead traveling vehicles and the local carriage stop the raising and lowering of the hoists as a result.

According to this, when the sensor detects an article that is horizontally swinging, communication that the communication terminal is performing with the overhead traveling vehicles or the local carriage ceases to be established, thus making it possible to cause the overhead traveling vehicles and the local carriage to automatically stop the hoists. Furthermore, compared to transmitting a transfer stop request signal or the like to the overhead traveling vehicles and the local carriage, transfer can be more reliably stopped by performing transfer on the condition of established communication, and cutting off communication when an abnormality occurs. Furthermore, transfer can be reliably stopped without involving a controller.

### BRIEF DESCRIPTION OF THE DRAWINGS

FIG. 1 is a side view of relevant portions of the overhead traveling vehicle system according to an embodiment.
FIG. 2 is a front view of relevant portions of the overhead traveling vehicle system according to the embodiment.
FIG. 3 is an enlarged plan view of relevant portions of the overhead traveling vehicle system according to the embodiment, in which an overhead traveling vehicle track are not shown.
FIG. 4 is a block diagram from a ground terminal to a ground controller according to the embodiment.
FIG. 5 is a block diagram of the overhead traveling vehicle system according to the embodiment.
FIG. 6 is a block diagram of the local carriage according to the embodiment.
FIG. 7 is a diagram showing the transfer protocol for a load port and a buffer.

### DETAILED DESCRIPTION OF THE PREFERRED EMBODIMENTS

The following describes a best mode for carrying out the present invention. The scope of the present invention is based on the recitation of the claims, and is intended to be determined in accordance with the understanding of a person skilled in the art with reference to the description of the present invention and well-known techniques in the field of the present invention.

### Embodiment

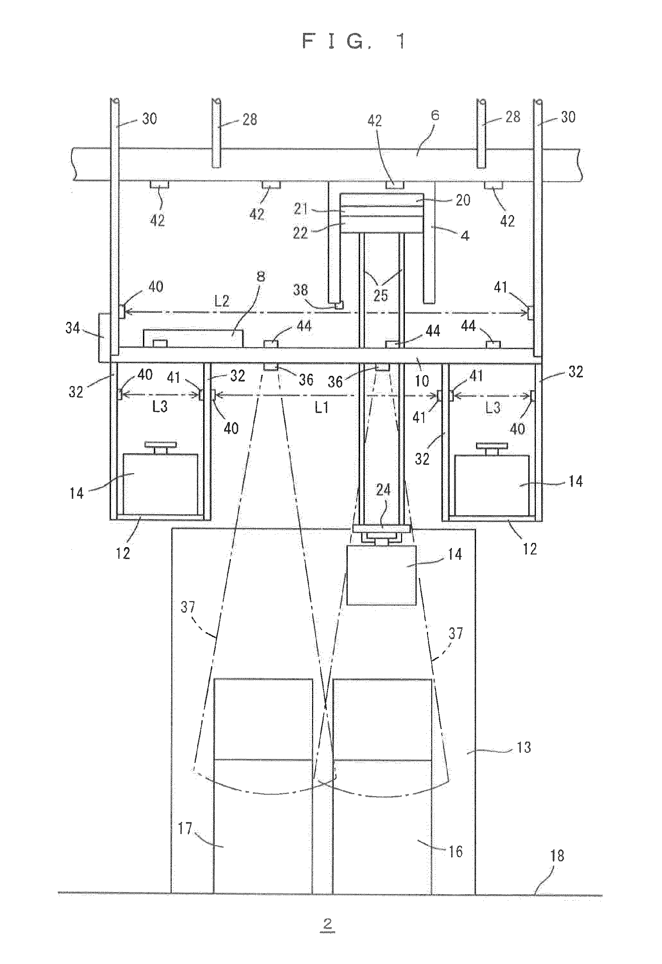

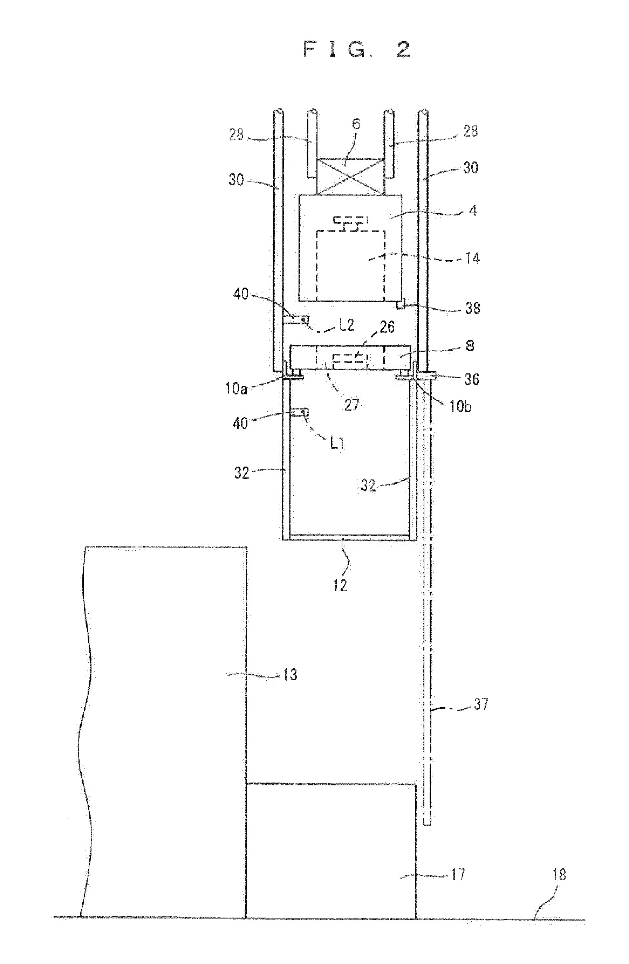

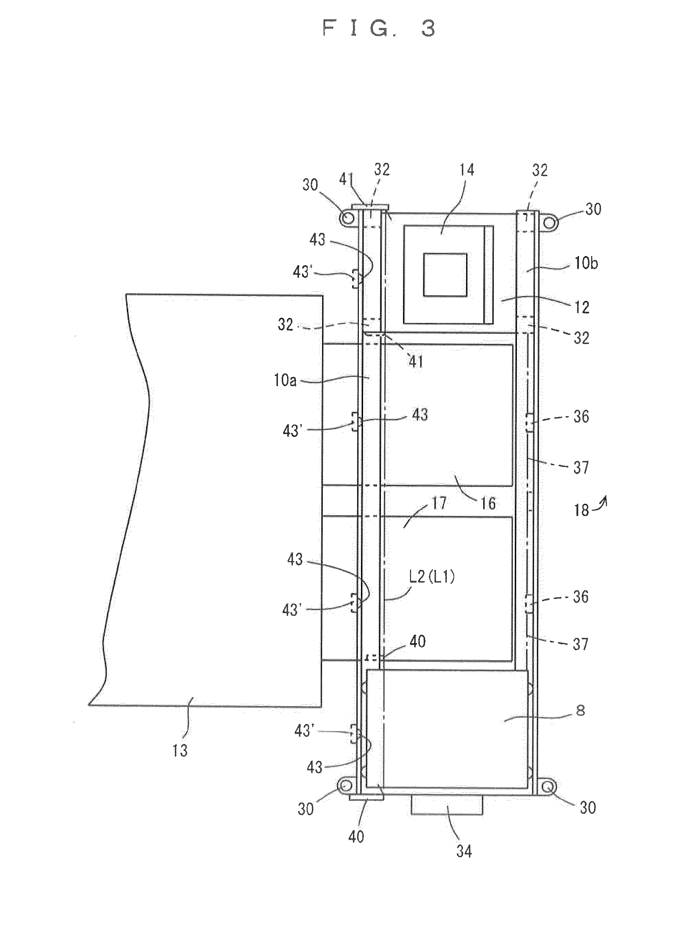

An overhead traveling vehicle system 2 according to an embodiment is shown in FIGS. 1 to 7. 4 indicates an overhead traveling vehicle that travels along an overhead traveling vehicle track 6, and 8 indicates a local carriage that travels along a local carriage track 10. The local carriage track 10 is provided only in the neighborhood of load ports 16 and 17, and the overhead traveling vehicle track 6, the local carriage track 10, and the load ports 16 and 17 are arranged so as to vertically overlap each other in the stated order. Also, as shown in FIGS. 2 and 3, the local carriage track 10 is made up of a pair of left and right rails, namely a rail 10b on a passageway 18 side and a rail 10a on a processing device 13 side. The gap between the rails 10a and 10b is wider than the left-right width of an article 14 in FIG. 2, thus making it possible for the article 14 and later-described elevation platforms 24 and 26 to vertically pass through the gap between the rails 10a and 10b. Note that the processing device 13 may be provided with one load port, or three or more of them.

12 indicates buffers provided at positions that are directly under the local carriage track 10 while being outside the region directly over the load ports 16 and 17, and the buffers 12 are for the placement of the articles 14, such as FOUPs. Buffers may be provided at other positions, but the buffers other than the buffers 12 directly under the track 10 are not directly related to the embodiment. Also, 18 indicates a passageway for operators and the like, and based on the load ports 16 and 17, one side in the horizontal plane is the processing device 13 side, and the other side is the passageway 18 side. Further, the passageway side of the load ports 16 and 17 is a monitoring area of downward monitoring sensors 36.

The overhead traveling vehicle 4 includes a lateral movement device 20, a rotation device 21, and a hoist 22, and the lateral movement device 20 laterally moves the rotation device 21 and the hoist 22 in a direction orthogonal to the track 6 in the horizontal plane so as to be able to access buffers (not shown) provided to the left and right of the track 6. The rotation device 21 rotates the hoist 22 so as to change the orientation of the articles 14. The hoist 22 raises and lowers an elevation platform 24 so as to move an article 14 between the load port 16 or 17 and a buffer 12, for example. Note that a configuration is possible in which the lateral movement device 20 and the rotation device 21 are not provided. 25 indicates belts that support the elevation platform 24, and these belts are made up of four belts of front, back, left, and right, for example, but other suspending members such as wires or ropes may be used in place of the belts 25. The hoist 22 raises and lowers the elevation platform 24 with a motor to wind the belts and unwind the belts while applying braking.

The local carriage 8 includes wheels, a running motor, and the like for traveling on the rails 10a and 10b, raises and lowers the elevation platform 26 by a hoist 27, and moves articles 14 between the buffers 12 and the load ports 16 and 17. The configuration of the hoist 27 is similar to the hoist 22 of the overhead traveling vehicle 4. In the overhead traveling vehicle system 2, the overhead traveling vehicle 4 and the local carriage 8 can both move articles 14 between the buffers 12 and the load ports 16 and 17. However, the overhead traveling vehicle system 2 may be operated such that the overhead traveling vehicle 4 carries articles to the buffers 12 and carries articles 14 from the load ports 16 and 17, and the local carriage 8 carries articles from the buffers 12 to the load ports 16 and 17, for example.

The tracks 6 and 10 are suspended from the ceiling side by vertical supports 28 and 30 for example, and the buffers 12 are suspended from the track 10 by vertical supports 32 that extend vertically downward. Also, the buffers 12 are provided along the lengthwise direction of the tracks 6 and 10 (the traveling direction of the overhead traveling vehicle 4 and the local carriage 8) on both the upstream side and the downstream side of the load ports 16 and 17, for example, but they may be provided on only either the upstream side or the downstream side. Further, members making up the buffers 12, such as horizontal frames thereof, are not provided directly over the load ports 16 and 17, so as to not hinder the buffers 12 from carrying articles 14 to and from the load ports.

A downward monitoring sensor 36 is provided directly over each of the load ports 16 and 17, and the downward monitoring sensors 36 monitor obstacles on the passageway side of the load ports 16 and 17. One example of an obstacle is an operator whose arm, helmet, or the like has come close to the load ports 16 and 17, and the downward monitoring sensors 36 are laser beam sensors that emit a beam 37 in a fan shape for example, and detect reflected light from an obstacle. FIGS. 1 to 3 show the shape of the beam 37, and the area on the passageway 18 side relative to the load ports 16 and 17 is monitored, excluding the load ports 16 and 17 and the path along which the articles 14 are raised from and lowered to the load ports 16 and 17. The overhead traveling vehicle 4 includes a similar downward monitoring sensor 38 in order to detect obstacles blocking the load ports 16 and 17, but there is a high possibility of mistakenly detecting the track 10 for the local carriage 8. In view of this, with respect to the load ports 16 and 17, the signal from the downward monitoring sensor 38 of the overhead traveling vehicle 4 is invalidated. Note that although a downward monitoring sensor 36 is provided for each of the load ports 16 and 17 in this embodiment, the adjacent load ports 16 and 17 may be monitored by one downward monitoring sensor.

Besides monitoring obstacles on the passageway 18 side from the load ports 16 and 17, horizontal swinging of articles 14 supported on the elevation platforms 24 or 26 is detected. Specifically, since articles 14 pass through the gap between the rails 10a and 10b, there is the possibility of contact with the rails 10a or 10b if the articles 14 horizontally swing in a direction orthogonal to the lengthwise direction of the local carriage track 10 in the horizontal plane. In particular, when an article 14 is raised, if the winding of the four belts 25 is not in synchronization, the possibility of horizontal swing starting is high. Also, there is a high possibility of horizontal swinging when articles 14 are raised from the load ports 16 and 17, whereas there is a low possibility of horizontal swinging when articles 14 are raised from the buffers 12. In view of this, horizontal swinging is detected based on whether or not an article 14 blocks a monitoring line (optical axis) at the same position as or slightly inward from the inward end of the rail 10a in a plan view over and under the track 10, for example.

In order to detect horizontal swinging, a light projecting and receiving sensor 40, which includes a light emitting element and a light receiving element, and a mirror 41 are arranged at respective ends of the monitoring line. The optical axis of light from the light emitting element is parallel with the lengthwise direction of the rails, and is outside of the raising and lowering path of an article that is not horizontally swinging. Both when an article 14 is raised to the overhead traveling vehicle 4 and when it is raised to the local carriage 8, it is raised to a height at which there is a risk of at least the top portion of the article 14 coming into contact with the rail 10a or 10b. Horizontal swinging of the article 14 therefore needs to be detected also when articles are raised to the local carriage 8. In view of this, a monitoring line (optical axis) L1 is provided at least at a position that is over the load ports 16 and 17 and under the local carriage track 10, and it is preferable that a monitoring line (optical axis) L2 is provided over the local carriage track 10 as well. In addition to this, a monitoring line (optical axis) L3 may be added at a position that is over the buffers 12 and under the local carriage track 10.

FIG. 3 shows the arrangement of the sensors 36 and 40, and the downward monitoring sensor 36 on the rail 10b side uses a beam 37 to monitor an area on the passageway side of the load ports 16 and 17. Also, the inward end of the rail 10a and the monitoring line L2 at the same position or slightly inward (toward the rail 10b) in a plan view are monitored by a light projecting and receiving sensor 40 and a mirror 41. Further, the monitoring line L1 is provided so as to be vertically overlapped with the monitoring line L2, and is monitored by a light projecting and receiving sensor 40 and a mirror 41 attached to vertical supports 32 or the like. Note that a combination of a light emitting element and a light receiving element may be used in place of the light projecting and receiving sensor 40 and the mirror 41. Further, a light projecting and receiving sensor 40 and a mirror 41 may be provided on the rail 10b side as well. Also, a proximity sensor 43 that monitors the electrostatic capacitance with the ground and detects the approach of an article 14 based on a change in the electrostatic capacitance, for example, may be used in place of the light projecting and receiving sensor 40 and the mirror 41. For example, a pole 43' extending in the up-down direction may be attached to the rail 10a, and the proximity sensor 43 may be attached to the pole 43'.

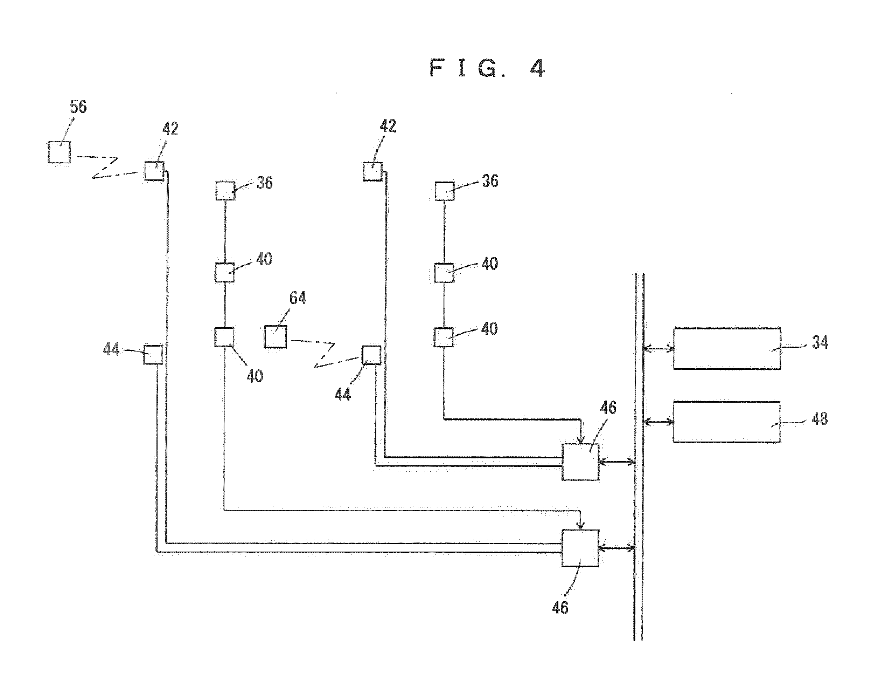

As shown in FIG. 1, a ground terminal 42 that communicates with a communication terminal of the overhead traveling vehicle 4 is provided at each transfer position along the track 6, and a ground terminal 44 that communicates with a communication terminal of the local carriage 8 is provided at each transfer position along the track 10. Note that the terminals 42 and 44 are not shown in FIGS. 2 and 3. FIG. 4 illustrates communication and monitoring when transfer is performed. The overhead traveling vehicle 4 includes a communication terminal 56, and the local carriage 8 includes a communication terminal 64. 34 indicates a local carriage controller that manages the local carriage and the carrying of articles to and from the buffers, and 48 indicates a controller on the processing device side that manages the carrying of articles to and from the load ports. A switch 46 is provided for each pair of a buffer and a load port, and these switches 46 connect the controllers 34 and 48 to the communication terminals 42 and 44 and enable communication between one of the communication terminals 42 and 44 and the overhead traveling vehicle 4 or the local carriage 8. Also, signals from the downward monitoring sensor 36 and the upper and lower light projecting and receiving sensors 40 are input to the switches 46, and when any of the sensors detects an obstacle, the switches 46 prohibit the communication that the communication terminals 42 and 44 perform with the overhead traveling vehicle 4 and local carriage 8.

The overhead traveling vehicle 4 and the local carriage 8 transmit a transfer request signal to the terminals 42 and 44 when transferring an article to or from a buffer or a load port. Transfer can be started upon receiving a transfer confirmation signal (a signal indicating that transfer is permitted) in response. Also, communication is maintained until transfer is complete, and if communication is interrupted during this time, the raising and lowering of the elevation platform is stopped, and the resumption of communication is waited for. The overhead traveling vehicle 4 and the local carriage 8 exchange signals with the terminals 42 and 44 until the transfer ends. Note that in place of blocking communication, obstacle detection signals may be transmitted to the overhead traveling vehicle 4 or the local carriage 8 using signals from the downward monitoring sensors 36 and the upper and lower light projecting and receiving sensors 40, but control becomes complicated since the number of types of signals increases.

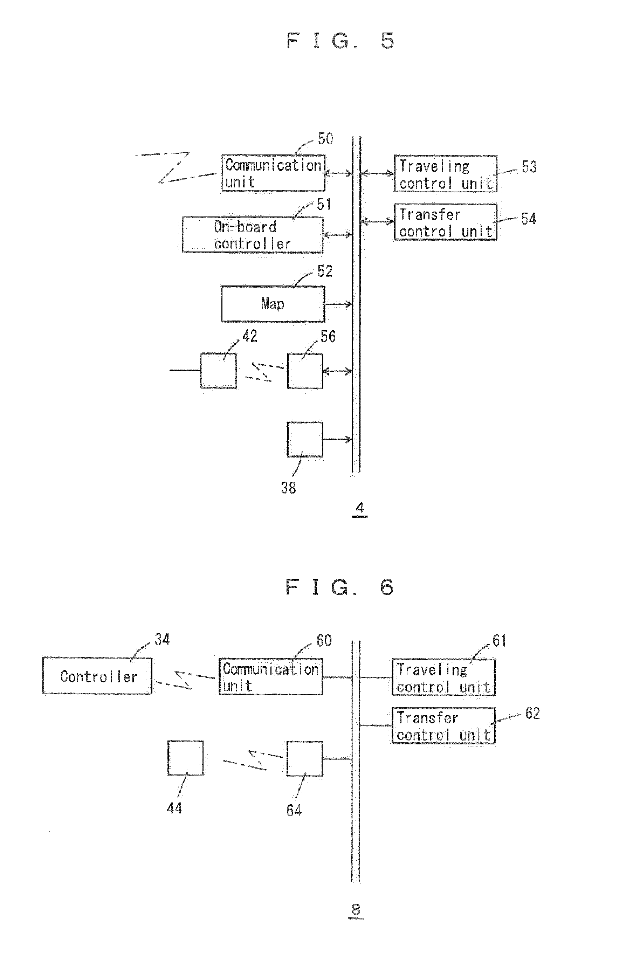

FIG. 5 shows the control system of the overhead traveling vehicle 4. A communication unit 50 communicates with an overhead traveling vehicle controller (not shown) and receives transport instructions, an on-board controller 51 performs overall control of the overhead traveling vehicle 4, and a map 52 stores arrangement data regarding the track 6. This data includes the transfer positions and whether or not monitoring by the downward monitoring sensor 38 is necessary during transfer, for example. According to the data in the map 52, downward monitoring is not necessary for the load ports 16 and 17 provided with the downward monitoring sensors 36, and the downward monitoring sensor 38 is switched off, or the signal therefrom is ignored. The communication terminal 56 communicates with the ground terminal 42, exchanges signals in accordance with the transfer protocol, and maintains communication during transfer. The traveling control unit 53 controls the traveling of the overhead traveling vehicle 4, and the transfer control unit 54 controls the hoist 22 and the like.

FIG. 6 shows the control system of the local carriage 8. A communication unit 60 communicates with the local carriage controller 34 and receives instructions. The communication terminal 64 communicates with the ground terminal 44, exchanges signals in accordance with the transfer protocol, and maintains communication during transfer. The traveling control unit 61 controls the traveling of the local carriage 8, and the transfer control unit 62 controls the hoist 27.

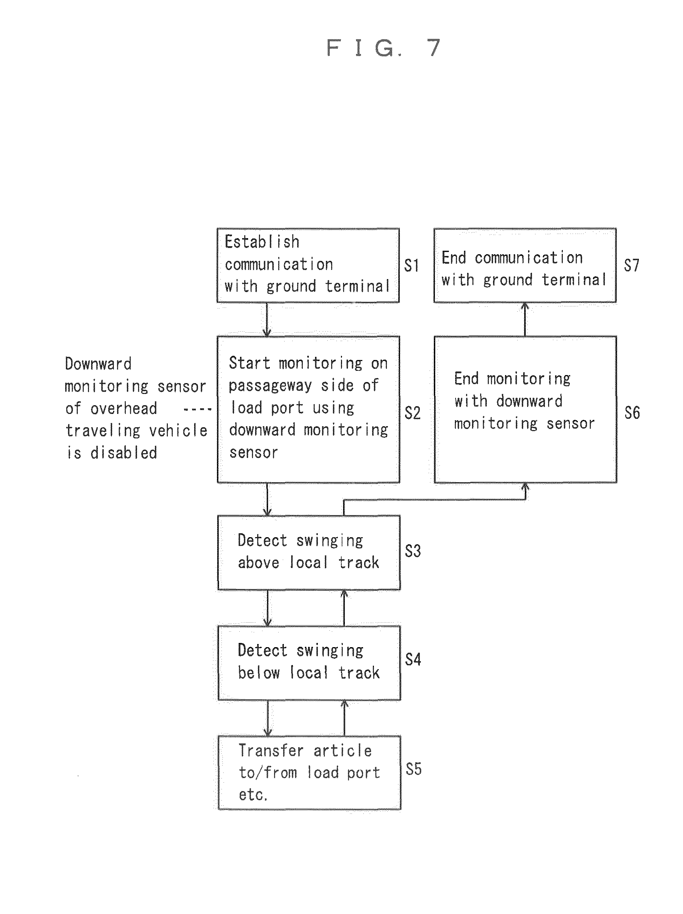

FIG. 7 illustrates the transfer protocol. Before transfer to and from the buffers 12 and the load ports 16 and 17, the overhead traveling vehicle 4 and the local carriage 8 establish communication with the ground terminals 42 and 44 (step 1). Hereinafter, the ground terminals 42 and 44 are assumed to be terminals corresponding to the same buffer 12 or the same load port 16 or 17. The switches 46 enable communication with only one of the ground terminals 42 and 44 at a time, and therefore it is not possible for the overhead traveling vehicle 4 and the local carriage 8 to start transfer to and from the same buffer 12 or the same load port 16 or 17 at the same time. Also, by default, the switches 46 are switched to a state in which the ground terminal 42 can perform communication, the ground terminal 44 cannot perform communication. The local carriage controller 34 changes the states of switches 46 so as to allow the communications via the ground terminals 44 for the region where the local carriage 8 is going to run. The state for communication with the ground terminals 42 or 44 cannot be changed from when communication starts until when transfer ends. According to this, the local carriage 8 cannot enter the region under the position where the overhead traveling vehicle 4 started communication. Also, the overhead traveling vehicle 4 cannot request communication in the region over the position where the local carriage 8 started communication.

The overhead traveling vehicle 4 and the local carriage 8 exchange transfer request signals and transfer confirmation signals with the ground terminals 42 and 44 before transfer starts, and then lower the elevation platforms and start transfer. For example, when transfer starts, the downward monitoring sensors 36 attached to the local carriage track 10 start performing monitoring (step 2), and when an obstacle such as a worker attempting to access the load port 16 or 17 is detected, the switches 46 prohibit communication with the ground terminals 42 and 44. When communication is cut off, the overhead traveling vehicle 4 and the local carriage 8 stop raising and lowering the elevation platforms, and wait until the downward monitoring sensors 36 no longer detect an obstacle. Also, in accordance with the data in the map, the downward monitoring sensor 38 of the overhead traveling vehicle 4 may be switched off, or the signal from the downward monitoring sensor 38 of the overhead traveling vehicle 4 may be ignored.

When an article 14 passes through the region over the local carriage track 10 and passes through the region just under it, horizontal swinging of the article is monitored by the light projecting and receiving sensor 40 (steps 3 and 4), and if the light projecting and receiving sensor detects a horizontally swinging article, the hoist is stopped, and subsiding of the horizontal swinging is waited for. This monitoring is performed in order to prevent the article from interfering with the local carriage track 10, and the monitoring of the region under the track 10 may be omitted when the elevation platform is being lowered. Note that with respect to the buffers 12, the monitoring of the region under the track 10 may be omitted due to the fact that, for example, the track 10 is passed immediately after rising starts.

After an article is transferred to and from the load port 16 or 17 or the buffer 12 (step 5), the elevation platform is raised. Monitoring by the downward monitoring sensors 36 continues, and horizontal swinging of an article is monitored by the light projecting and receiving sensors 40 when the article passes through the region just under the local carriage track 10 and passes through the region over it (steps 3 and 4). Also, the monitoring of the region over the track 10 may be omitted when the elevation platform is being raised.

When the elevation platform has returned to the vehicles , monitoring by the downward monitoring sensors is ended (step 6), the overhead traveling vehicle 4 and the local carriage 8 exchange a signal indicating that transfer ended with the ground terminals 42 and 44, and communication is ended (step 7). Note that the monitoring by the downward monitoring sensors may be ended when, for example, the article has been raised to the vicinity of the track 10.

Advantages described below are obtained in this embodiment.
1) The frame or the like of the buffers 12 are not provided directly over the load ports 16 and 17, thus facilitating the transfer of articles 14.
2) An obstacle directly under is detected by the downward monitoring sensors 36 attached to the rail 10b, thus making it possible to reliably detect obstacles on the passageway side of the load ports 16 and 17.
3) The downward monitoring sensor 38 of the overhead traveling vehicle 4 is not used, thus preventing the local carriage track 10 or the like from being mistakenly detected as an obstacle.
4) Horizontal swinging of an article 14 is detected by the light projecting and receiving sensors 40 before the article 14 passes through the local carriage track 10, thus making it possible to prevent the article 14 from coming into contact with the local carriage track 10.
5) The downward monitoring sensors 36 and the light projecting and receiving sensors 40 can be used for both the overhead traveling vehicle 4 and the local carriage 8.
6) Both when a downward monitoring sensor 36 detects an obstacle, and when a light projecting and receiving sensor 40 detects horizontal swinging, the raising and lowering the elevation platforms can be stopped by prohibiting communication with the ground terminals 42 and 44.
7) Communication is prohibited by the switches 46 based on signals from the downward monitoring sensors 36 or the light projecting and receiving sensors 40, without involving the controllers 34 and 48, thus making it possible to more reliably stop the transfer.

### List of Reference Numerals

- 2: Overhead traveling vehicle system
- 4: Overhead traveling vehicle
- 6: Overhead traveling vehicle track
- 8: Local carriage
- 10: Local carriage track
- 12: Buffer
- 13: Processing device
- 14: Article
- 16, 17: Load port
- 18: Passageway
- 20: Lateral movement device
- 21: Rotation device
- 22, 27: Hoist
- 24, 26: Elevation platform
- 25: Belt
- 28-32: Vertical support
- 34: Local carriage controller
- 36, 38: Downward monitoring sensor
- 37: Laser beam
- 40: Light projecting and receiving sensor
- 41: Mirror
- 42, 44: Ground terminal
- 43: Proximity sensor
- 46: Switch
- 48: Controller on processing device side
- 50, 60: Communication unit
- 51: On-board controller
- 52: Map
- 53, 61: Traveling control unit
- 54, 62: Transfer control unit
- 56, 64: Communication terminal
- L1-L3: Monitoring line

## Claims

1. An overhead traveling vehicle system comprising:
overhead traveling vehicles that have a hoist for raising and lowering an article;
a track for said overhead traveling vehicle;
a load port provided in a front surface of a processing device;
a local carriage track that is arranged at a position that is directly over the load port and directly under the overhead traveling vehicle track, is arranged parallel to the overhead traveling vehicle track, and comprises a pair of rails;
a local carriage that includes a hoist for raising and lowering an article and travels along the local carriage track; and
a sensor that detects an article horizontally swinging in a direction orthogonal to a lengthwise direction of the local carriage track in a horizontal plane,
wherein the pair of rails of the local carriage track are configured to allow articles pass vertically between the pair of rails by means of the hoists of the overhead traveling vehicles,
both the overhead traveling vehicles and the local carriage are configured to carry articles to and from the load port by means of the hoists,
the sensor is provided at least at a position that is under the local carriage track and is outside of a raising and lowering path of an article that is not horizontally swinging, and
the overhead traveling vehicles and the local carriage are each configured and programmed to stop the raising and lowering of the hoist when the sensor detects an article that is horizontally swinging.

2. The overhead traveling vehicle system according to claim 1,
wherein the sensor comprises:
a light projecting element that projects light along an optical axis that is parallel to the local carriage track and is outside of the raising and lowering path of an article that is not swinging; and
a light receiving element that detects blockage of the optical axis by an article that is horizontally swinging.

3. The overhead traveling vehicle system according to claim 1 or 2,
wherein in addition to the sensor at the position under the local carriage track, an additional sensor is provided at a position that is over the local carriage track and is outside of the raising and lowering path of an article that is not horizontally swinging.

4. The overhead traveling vehicle system according to any of claims 1 to 3,
wherein communication terminals are respectively provided on the overhead traveling vehicle track and the local carriage track,
a switch is provided that establishes communication selectively between the overhead traveling vehicles or the local carriage and one of the communication terminals based on a condition that the sensor has not detected an article that is horizontally swinging,
the overhead traveling vehicles and the local carriage are configured to carry articles to and from the load port while communicating with the communication terminal, and
when the sensor detects an article that is horizontally swinging, communication performed by the communication terminal with the overhead traveling vehicles or the local carriage is cut off, and the overhead traveling vehicles and the local carriage stop the raising and lowering of the hoists as a result.

5. A control method for an overhead traveling vehicle system that comprises
overhead traveling vehicles that have a hoist for raising and lowering an article; an overhead traveling vehicle track;
a load port provided in a front surface of a processing device;
a local carriage track that is arranged at a position that is directly over the load port and directly under the overhead traveling vehicle track, is arranged parallel to the overhead traveling vehicle track, and comprises a pair of rails; and
a local carriage that includes a hoist for raising and lowering an article and travels along the local carriage track,
the pair of rails of the local carriage track being configured to allow articles pass vertically between the pair of rails by means of the hoists of the overhead traveling vehicles, and
both the overhead traveling vehicles and the local carriage being configured to carry articles to and from the load port using the hoists, the control method comprising:
a step for providing a sensor at least at a position that is under the local carriage track and is outside of a raising and lowering path of an article that is not horizontally swinging, the sensor detecting an article horizontally swinging in a direction orthogonal to a lengthwise direction of the local carriage track in a horizontal plane; and
a step for causing the overhead traveling vehicles and the local carriage to stop the raising and lowering of the hoists when the sensor detects an article that is horizontally swinging.
